# EUROPÄISCHE PATENTSCHRIFT

(11) **EP 2 751 850 B1**
(45) Veröffentlichungstag und Bekanntmachung des Hinweises auf die Patenterteilung: **02.05.2018**
(21) Anmeldenummer: 12755851.8
(22) Anmeldetag: 03.09.2012
(51) Int. Cl.: H01L 31/05, H01L 31/052, H01L 31/056

(54) **VERFAHREN ZUM VERBINDEN VON SOLARZELLEN**
METHOD FOR CONNECTING SOLAR CELLS
PROCÉDÉ DE CONNEXION DE CELLULES SOLAIRES

(30) Priorität: 02.09.2011 DE 102011053238
(43) Veröffentlichungstag der Anmeldung: 09.07.2014
(73) Patentinhaber: Fraunhofer-Gesellschaft zur Förderung der angewandten Forschung e.V., 80686 München (DE)
(72) Erfinder: VON CAMPE, Hilmar, 61352 Bad Homburg (DE); DRÖSSLER, Raimund, 63849 Leidersbach (DE); GASSENBAUER, Yvonne, 63768 Hösbach (DE); HEYER, Fritz, 63755 Alzenau (DE); METZ, Axel, 63755 Alzenau (DE); MOSCHNER, Jens Dirk, 63755 Alzenau (DE)
(86) Internationale Anmeldenummer: PCT/EP2012/067101
(87) Internationale Veröffentlichungsnummer: WO 2013/030407

(56) Entgegenhaltungen:
- EP-A2- 2 003 699
- WO-A1-98/49735
- US-A- 4 336 648
- US-A1- 2007 125 415
- US-A1- 2010 108 123
- ELGAMEL H E ET AL: "EFFICIENT COMBINATION OF SURFACE AND BULK PASSIVATION SCHEMES OF HIGH-EFFICIENCY MULTICRYSTALLINE SILICON SOLAR CELLS", JOURNAL OF APPLIED PHYSICS, AMERICAN INSTITUTE OF PHYSICS. NEW YORK, US, Bd. 78, Nr. 5, 1. September 1995 (1995-09-01), Seiten 3457-3461, XP000541608, ISSN: 0021-8979, DOI: 10.1063/1.359977

## Beschreibung

Die Erfindung bezieht sich auf ein Verfahren zum Verbinden von Solarzellen zur Herstellung eines Solarzellenmoduls mittels abwechselnd entlang von Rückseiten und Busbars aufweisenden Frontseiten von aufeinanderfolgenden Solarzellen verlaufenden und mit diesen elektrisch leitend verbundenen Verbindern, deren Anzahl der des Busbars entspricht und die jeweils streifenförmiger Geometrie mit gegenüberliegenden Flachseiten aufweisen, wobei die solarzellenfrontseitig verlaufende Flachseite mit einem Material und/oder einer Struktur versehen wird, das bzw. die Strahlen reflektiert und in den verbleibenden Abschnitten des Verbinders unveränderte strukturelle Eigenschaften vorhanden sind.
Um Solarzellen zu einem Modul zu verschalten, werden erstere entsprechend der Anzahl der Busbars, die entlang der Frontseiten der Solarzellen verlaufen, über elektrische Verbinder verschaltet, die bei Frontseitenkontaktsolarzellen abwechselnd entlang der Vorderseite und Rückseite von aufeinanderfolgenden Solarzellen verlaufen. Die Verbinder, die üblicherweise aus Kupfer oder Aluminium bestehende Folienstreifen sind, weisen hierzu eine aus Lotmaterial wie Zinn bestehende Beschichtung auf, um die Verbinder stoffschlüssig mit den Rückseiten bzw. den Busbars der Frontseiten der Solarzellen durch Löten zu verbinden.
Entsprechend verschaltete Solarzellen sind zur Bildung eines Moduls in Kunststoffe wie EVA eingebettet, wobei das Modul frontseitig insbesondere von einer Glasscheibe und rückseitig von einer Glasscheibe oder einer Rückseitenfolie abgedeckt ist. Ferner ist das Modul von einem Rahmen umgeben.
Um Strahlungsverluste durch die entlang der Frontseiten verlaufenden Verbinder, und zwar durch Absorption der Strahlung zu reduzieren, wodurch der Wirkungsgrad der Solarzelle verringert wird, ist es bekannt, die Verbinder zu strukturieren derart, dass sich im Längsschnitt eine sägezahnartige Struktur ergibt. Die Oberfläche wird sodann zusätzlich mit Silber beschichtet, um eine hohe Reflexionsrate zu erzielen. Die Strukturierung ist über die gesamte Länge der Verbinder ausgebildet, so dass erhebliche Kontaktprobleme beim elektrisch leitenden Verbinder mit den Rückseiten entstehen, da die rückseitig zugewandte Seite der Verbinder die Sägezahnstruktur mit der Silberschicht aufweist. Durch aufwendige Maßnahmen werden in den Abschnitten, in denen eine Verbindung zu den Rückseiten erfolgt, Lotmaterialien in die Sägezahnstruktur eingebracht, um die Verbinder mit den Rückseiten verlöten zu können.
Der WO 2008/094048 A1 sind Verbinder für Solarzellen zu entnehmen. Die Verbinder sind dabei derart strukturiert, dass sich im Längsschnitt eine sägezahnartige Struktur ergibt.

Der US 2009/0255569 A1 ist ein Solarzellenmodul zu entnehmen, bei dem die Solarzelle über Verbinder verschaltet ist, die frontseitig eine Mikrostruktur aufweisen. Auch kann eine reflektierende Schicht aufgebracht werden.
Nach der EP2 003 699 A1 wird in die Rückseite einer konventionellen Solarzelle mittels Ultraschall ein Lotmaterial einlegiert.
Die DE20 2008 016 139 U1 bezieht sich auf einen Solarzellenverbund.

Der WO95/15582 A1 ist ein Solarzellenverbund zu entnehmen, bei dem Streifen reflektierenden Materials auf den Frontseiten der Solarzellen in deren inaktiven Bereichen aufgebracht sind.

Ein Verfahren der eingangs genannten Art ist der US 2007/01254154 A1 zu entnehmen. Die z.B. mit Zinn beschichteten Verbinder weisen in den Abschnitten, die entlang von Frontseiten der Solarzellen verlaufen, eine Struktur auf. In ihren entlang von Rückseiten von Solarzellen verlaufenden Abschnitten ist eine Struktur nicht vorhanden.

Der vorliegenden Erfindung liegt die Aufgabe zugrunde, ein Verfahren zum Herstellen und Verbinden von Solarzellen zu einem Solarzellenmodul zur Verfügung zu stellen, das einen hohen Wirkungsgrad aufweist.

Zur Lösung der Aufgabe sieht die Erfindung ein Verfahren zum Verbinden von Solarzellen zur Herstellung eines Solarzellenmoduls mittels abwechselnd entlang von Rückseiten und Busbars aufweisenden Frontseiten von aufeinanderfolgenden Solarzellen verlaufenden und mit diesen elektrisch leitend verbundenen Verbindern, deren Anzahl der der Busbars entspricht und die jeweils streifenförmiger Geometrie mit gegenüberliegenden Flachseiten aufweisen, wobei die solarzellenfrontseitig verlaufende Flachseite mit einem Material und/oder einer Struktur versehen wird, das bzw. die Strahlen reflektiert und in den verbleibenden Abschnitten des Verbinders unveränderte strukturelle Eigenschaften vorhanden sind, wobei als Solarzellen solche mit einem siliciumbasierten und p- oder n-leitenden Wafer verwendet werden, auf dessen Rückseite eine lokale Öffnungen aufweisende Schicht aus passivierendem dielektrischen Material angeordnet wird, die von einer die Rückseite des Wafers vollflächig abdeckenden aus Aluminium bestehenden oder Aluminium enthaltenden gesinterten Schicht abgedeckt wird, wobei auf die Sinterschicht im Bereich des zu kontaktierenden Verbinders mittels Ultraschall ein aus Lotmaterial bestehender Streifen aufgetragen wird, wobei der Verbinder mit dem Streifen stoffschlüssig verbunden wird, wobei der Verbinder auf beiden Flachseiten Lotmaterial aufweist und wobei das Versehen mit dem reflektierenden Material und/oder der Struktur während oder nach dem Verbinden der Solarzelle mit dem Verbinder erfolgt.
Erfindungsgemäß werden Solarzellen mit einer PERC-Struktur mit gegebenenfalls selektiven Emittern und konventionell verfügbarem Verbinder benutzt, der beim Zuführen des Verbinders zu den verschaltenden Solarzellen bzw. nach dem Verschalten derart prozessiert wird, dass sich ausschließlich in den Abschnitten bzw. Bereichen, die entlang der Frontseiten der zu verschaltenden Solarzellen verlaufen, Eigenschaften ergeben, die zu einer Reflexion der Strahlung mit der Folge führen, dass diese an der frontseitigen Abdeckung reflektiert werden kann und somit in den aktiven Bereich der Solarzellen zurückgelangt.
Geeignet hierzu ist auch eine Strukturierung der frontseitig verlaufenden Abschnitte des Verbinders, da diese nicht in den entlang der Rückseite der Solarzelle verlaufenden Abschnitten ausgebildet wird mit der Folge, dass ein problemloses stoffschlüssiges Verbinden insbesondere durch Löten ermöglicht wird.
Es werden insbesondere beidseitig verzinnte Verbinder verwendet, die insbesondere nach der Verstringung im Bereich der Frontseite, also der strahlungszugewandten Flachseite eine reflektierte Schicht dadurch erhalten, dass eine entsprechende Schicht aufgebracht wird, oder dass dem Lotmaterial, wie Zinn, auf der Frontseite eine reflektierende Struktur eingeprägt wird. Es besteht jedoch auch die Möglichkeit, eine retroreflektierende ebene Struktur aufzukleben oder z. B. eine reflektierende Aluminiumfolie mit Schutzoxid aufzutragen oder eine gut reflektierende Farbe.

Insbesondere ist vorgesehen, dass als reflektierendes Material zumindest ein solches aus der Gruppe Ag, Al₂O₃, TiO₂, Aluminiumfolie mit gegebenenfalls Schutzoxid, reflektierende Farbe verwendet wird. Es kann jedoch auch ein Mehrschichtsystem mit alternierendem Brechungsindex aufgetragen werden, wie Bragg-Schichten.
Erwähntermaßen wird das Beschichten bzw. Strukturieren der entlang der Frontseite der zu verschaltenden Solarzellen verlaufenden Abschnitte des Verbinders bei der Herstellung des Moduls, insbesondere nach der Verschaltung, durchgeführt, wobei die Strukturgebung z. B. mittels eines auf die Lotmaterialbeschichtung des Verbinders einwirkenden Stempels erfolgen kann.
Insbesondere ist vorgesehen, dass als Verbinder ein solcher aus einem aus Kupfer oder Aluminium bestehenden oder enthaltenden Folienstreifen mit einer Breite B mit 1 mm ≤ B ≤ 3 mm und /oder einer Dicke D_{F} mit 50 µm ≤ D_{F} ≤ 250 µm verwendet wird, wobei das Lotmaterial auf der Flachseite mit einer Schichtdicke D_{L} mit 10 µm ≤ D_{L} ≤ 20 µm und/oder das reflektierende Material mit einer Schichtdicke D_{R} mit 0,1 µm ≤ D_{R} ≤ 5 µm, insbesondere 1 µm ≤ D_{R} ≤ 2 µm aufgetragen ist. Die angegebene Schichtdicke für das reflektierende Material gilt insbesondere dann, wenn dieses aus Silber besteht. Ein höherer Wirkungsgrad des Moduls wird durch die Verwendung von PERC-Zellen sowie strukturierte und/oder reflektierende Verbinder erzielt. Die von dem strukturierten bzw. reflektierenden Verbinder reflektierte Strahlung wird durch Totalreflexion an der Frontglasoberseite schräg auf die Randbereiche der an den Verbinder angrenzenden Solarzellenbereiche gespiegelt, wodurch ein zusätzlicher Beitrag zum Photostrom erzielt wird.

Weitere Einzelheiten, Vorteile und Merkmale der Erfindung ergeben sich aus der nachfolgenden Beschreibung von der Zeichnung zu entnehmenden bevorzugten Ausführungsbeispielen.

Es zeigen:
- Fig. 1: einen Ausschnitt aus einem Solarzellenmodul,
- Fig. 2: einen Ausschnitt einer ersten Rückseite einer Solarzelle,
- Fig. 3: einen Ausschnitt einer zweiten Rückseite einer Solarzelle,
- Fig. 4a-4c: Querschnitte von Abschnitten von Verbindern, die solarzellenfrontseitig verlaufen, und
- Fig. 5: Querschnitte von Abschnitten von Verbindern, die solarzellenrückseitig verlaufen.

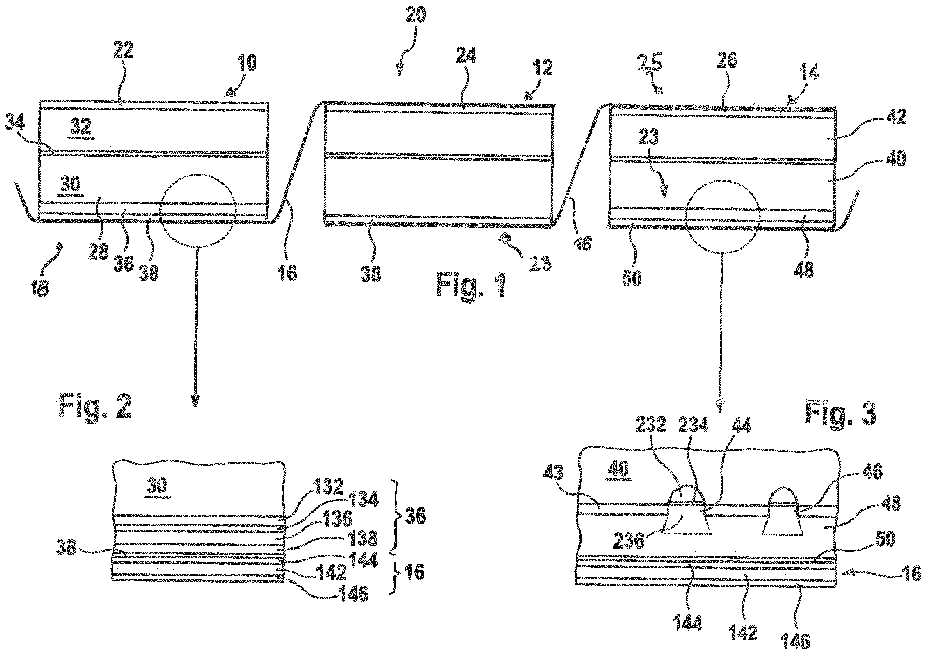

Die Erfindung wird nachstehend anhand von den Figuren 1, 3, 4a, 4c und 5a beschrieben. Die Figuren 2, 4b und 5b zeigen Alternativstrukturen, die nicht in Übereinstimmung mit der Erfindung sind.

Das erfinderische Verfahren wird nachstehend anhand von zu einem Solarzellenmodul zu verschaltenden Solarzellen beschrieben. Das Modul kann einen typischen Aufbau aufweisen, also frontseitig, der Strahlung zugewandt, eine Glasscheibe, eine transparente Kunststoffschicht wie Ethylenvinylacetat (EVA) oder Silicon, in der die Solarzellen eingebettet sind, die über Verbinder verschaltet sind, sowie eine Rückseitenabdeckung, die aus Glas oder aus einer Kunststoffverbundfolie wie Polyvinylfluorid (TEDLAR) und Polyester bestehen kann. Ein entsprechendes Modul ist sodann von einem Rahmen umgeben.

In der Fig. 1 sind im Schnitt und rein prinzipiell drei Solarzellen 10, 12, 14 dargestellt, die über Verbinder 16 verschaltet bzw. verstringt sind. Die Verbinder 16 verlaufen abwechselnd entlang der Rück- und Frontseiten von aufeinanderfolgenden Solarzellen, also im Ausführungsbeispiel entlang der Rückseite 18 der Solarzelle 10, entlang der der einfallenden Strahlung zugewandten Frontseite 20 der Solarzelle 12, entlang der Rückseite 23 der Solarzelle 12 und sodann entlang der Frontseite 25 der Solarzelle 14.

Die Anzahl der Verbinder 16 richtet sich nach der Anzahl der entlang der jeweiligen Frontseite verlaufenden Busbars 22, 24, 26, die auch als Stromableiter bezeichnet werden können. Zu den Busbars 22, 24, 26 führen in gewohnter Weise nicht dargestellte Stromsammler oder Finger. Insoweit wird auf übliche konstruktive Gestaltungen von Solarzellen verwiesen, wobei es sich erfindungsgemäß um siliciumbasierte kristalline PERC-Solarzellen handelt.

Erfindungsgemäße Merkmale werden anhand der Solarzelle 10 beschrieben, auch wenn diese keine PERC-Zelle ist.

Die Solarzelle 10 weist einen Wafer 28, der siliciumbasiert ist und einen rückseitigen p- oder n-leitenden Bereich 30, einen frontseitigen n- bzw. p-leitenden Bereich 32 und einen zwischen diesen verlaufenden pn-Übergang 34 auf. Rückseitig ist der Wafer 28 von einer gesinterten Aluminiumschicht 36 abgedeckt, auf der entsprechend der Anzahl der Verbinder und deren Verlauf vorgebend mittels Ultraschall Lötbahnen 38 aufgebracht sind. Insoweit kann eine Technik zur Anwendung gelangen, wie diese der DE-A-10 2010 00 520 zu entnehmen ist, auf deren Offenbarung ausdrücklich Bezug genommen wird.
Die Rückseitenschicht 36 ist - jedoch nicht maßstabsgetreu - detaillierter der Fig. 2 zu entnehmen. An den p-leitenden Bereich 30 des Wafers 28 schließt sich eine Aluminium- dotierte Siliciumschicht 132, ein Al-Si-Eutektikum 134 und eine Silicium-dotierte Aluminiumschicht 136 an, auf der die gesinterte Aluminiumschicht 138 verläuft. Auf der Aluminiumschicht 138 verläuft die mittels Ultraschall aufgebrachte Lotbahn 38, auf der der Verbinder 16 aufgelötet ist. Insoweit wird auf die EP-A-2 003 699 verwiesen, in der die Ausbildung der Schichten und die Kontaktierung mit dem Lotmaterial beschrieben ist.

Der Verbinder 16 kann aus einem aus Kupfer oder Aluminium bestehendem Folienstreifen 142 bestehen, dessen Flachseiten jeweils mit einer insbesondere aus Zinn bestehenden Lotschicht 144, 146 versehen sind, also im rückseitigen Bereich der Solarzelle 12 aus einem klassischen Verbinder, wie dieser zum Verschalten von Solarzellen zum Einsatz gelangt.
Erfindungsgemäß sind die Solarzellen als PERC-Zellen (Passivated Emitter and Rear Cells) ausgebildet. Ein Ausschnitt der Rückseite einer entsprechenden PERC-Zelle ist der Fig. 3 zu entnehmen.

Auf einem ebenfalls siliciumbasierten z. B. p-leitenden Bereich 40 des Wafers 42 der Solarzelle 14 ist eine lokale Öffnungen 44, 46 aufweisende Schicht 43 aus passivierendem dielektrischen Material angeordnet. Hierbei handelt es sich insbesondere um SiNₓ oder andere geeignete Materialien, wie diese auch in der EP-B-2 215 663 beschrieben sind. Die Öffnungen 44, 46 können dabei beliebige Geometrien aufweisen. Die passivierende dielektrische Schicht 43 auf der Rückseite des Wafers 42 ist sodann - entsprechend der Fig. 2 - vollflächig von einer aus Aluminium bestehenden oder Aluminium enthaltenden Sinterschicht 48 abgedeckt, die sich durch die lokalen Öffnungen 44, 46 bis zur Rückseite des Wafers 42 mit der Folge erstreckt, dass sich im Bereich der Öffnungen 44, 46 die Bereiche ausbilden, die in Fig. 2 mit dem Bezugszeichen 132 bis 136 gekennzeichnet sind, also der Aluminium-dotierte Siliciumbereich 232, das Al-Si-Eutektikum 234 sowie der Silicium-dotierte Aluminiumbereich 236. Zwischen diesen bis zur Außenseite der Rückseitenschicht 48 verläuft die gesinterte Aluminiumschicht. Somit finden sich unmittelbar im Bereich der aus dielektrischem Material bestehenden Schicht 43 andere Verhältnisse als im Bereich der lokalen Öffnungen 44, 46; denn unmittelbar über der Schicht 43 verlaufen weder die dotierten Bereiche noch das Eutektikum. Ungeachtet dessen hat sich überraschenderweise herausgestellt, dass auch im Bereich der lokalen Öffnungen 44, 46 mittels Ultraschall streifenförmig Lot aufgebracht werden kann, das die erforderliche elektrisch leitende Verbindung zu dem Wafer herstellt.

Um den Wirkungsgrad eines entsprechenden Solarzellenmoduls zu optimieren, also Hochleistungssolarzellen basierend auf mono- oder polykristallinem Silicium mit passivierter Rückseite und rückseitig verlaufender Aluminiumschicht zu einem Modul verschaltet werden, ist erfindungsgemäß vorgesehen, dass die Leiter 16 ausschließlich in den Bereichen, in denen diese entlang der Frontseiten der Solarzellen - im Ausführungsbeispiel also entlang der Frontseite 20 der Solarzelle 12 verlaufen, durch Strukturgebung und/oder Beschichtung reflektierende Eigenschaften erhalten, durch die auf die Verbinder 16 auftreffende Strahlung zurückreflektiert und sodann durch den Brechungsindexsprung an der Modulglasoberseite in die Solarzellen zurückgespiegelt wird, ohne dass Nachteile in Bezug auf die stoffschlüssige Verbindung der Verbinder

16 mit den Rückseiten der Solarzellen erfolgen, also im vorliegenden Fall mit den Rückseiten der Solarzellen 10 und 14.
Es sollen folglich im Rückseitenbereich übliche Verbindungstechniken zum Einsatz gelangen, die die erforderliche elektrisch leitende Verbindung mit geringem Übergangswiderstand sicherstellen. Entlang der Rückseite der Aluminiumschicht 48 wird hierzu mittels Ultraschall eine Lötbahn 50 aufgebracht, mit der stoffschlüssig durch Löten der Verbinder 16 kontaktiert wird, der eine Schichtstruktur aufweist, wie diese im Zusammenhang mit der Fig. 2 erläutert worden ist, so dass gleiche Bezugszeichen Verwendung finden.
Die zur Strahlenreflexion gewählten Maßnahmen gelangen ausschließlich in den Abschnitten der Verbinder 16 zur Anwendung, die entlang der Frontseiten der Solarzellen verlaufen und diese elektrisch leitend verbinden. Die Verbinder 16 sind in diesen Bereichen mit den entsprechenden Busbars 24 stoffschlüssig, durch Löten verbunden. Dabei werden den entsprechenden Abschnitten der Verbinder die reflektierenden Eigenschaften insbesondere nach dem Verschalten zugeführt, sei es durch Prägen, sei es durch Beschichten. Die reflektierenden Eigenschaften können jedoch auch gleichzeitig mit dem stoffschlüssigen Verbinden ausgebildet werden.

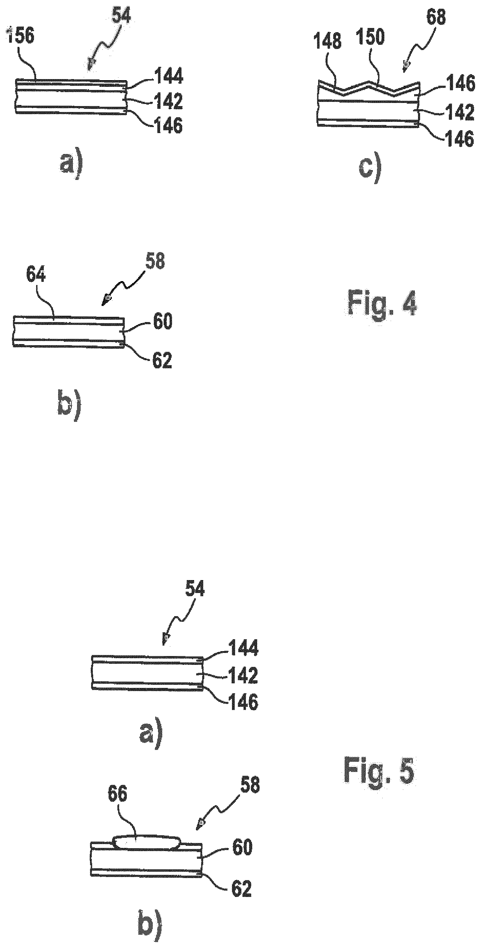

Der Fig. 4 sind Querschnitte verschiedener Formen von Verbindern zu entnehmen, und zwar in den Abschnitten bzw. Bereichen, die entlang der zu verschaltenden Frontseiten der Solarzellen verlaufen.

In den Fig. 4a), 5a) ist ein Querschnitt einer ersten erfindungsgemäßen Ausführungsform eines Verbinders 54 dargestellt, der dem Verbinder 16 gemäß den Erläuterungen der Fig. 3 entspricht, also aus einer streifenförmigen Metallfolie aus Aluminium oder Kupfer als mittlere Schicht 142 besteht, deren Flachseiten jeweils mit den Schichten 144, 146 aus Lotmaterial wie Zinn versehen sind. Davon abgesehen können auch die rechte und linke Seite, also die Schmalseiten des Verbinders, mit dem Lot beschichtet sein. Entsprechend wird der Verbinder über die Lotschicht 144 mit den Rückseiten der Solarzellen 10, 14 stoffschlüssig verbunden. Im Bereich der Frontseite 20 der Solarzelle 12 weist die äußere Lotschicht 144 eine Strahlung reflektierende weitere Schicht 156 auf, die eben ausgebildet ist und z. B. aus Silber besteht oder Silber enthalten kann. Andere geeignete reflektierende Materialien wie reflektierende Aluminiumfolie mit einem Schutzoxid oder reflektierende wie hellweiße Farben kommen als Schicht 156 gleichfalls in Frage. Beispiele von reflektierenden Materialien sind z. B. Titanoxid oder Aluminiumoxid. Auch können Mehrschichtsysteme mit alternierendem Brechungsindex aufgetragen werden.
Die die Strahlung reflektierende Schicht 156 sollte eine Dicke D_{R} im Bereich zwischen 0,1 µm und 5 µm aufweisen. Die Lotschichten 144, 146 können jeweils eine Schichtdicke zwischen 10 µm und 20 µm und die Dicke der Kupfer- bzw. Aluminiumfolie 142 zwischen 150 µm und 250 µm bei einer Breite zwischen 1 mm und 3 mm aufweisen.

Entsprechend der Darstellung der Fig. 4b, die nicht in Übereinstimmung mit der Erfindung ist, besteht die Möglichkeit, einen Verbinder 58 zu verwenden, der aus einer ebenfalls z. B. aus Kupfer oder Aluminium oder einem Verbund aus diesen oder bestehenden streifenförmigen Metallfolie 60 zuvor angegebener Dimensionierung und rückseitiger Lotschicht 62 wie Zinn besteht. Der Verbinder 58 und damit die Lotschicht 62 ist dabei derart ausgerichtet, dass beim Verschalten der Solarzellen 10, 12, 14 diese entlang der Frontseite 20 der Solarzelle 12 verläuft, also der Verbinder 58 über die Lotschicht 62 mit den Busbars 24 der Solarzelle 12 stoffschlüssig verbunden wird. Der Verbinder 58 weist des Weiteren frontseitig eine Schicht aus reflektierendem Material 64 auf, wobei Materialien und Gestaltungen zur Anwendung gelangen, wie diese im Zusammenhang mit der Schicht 156 erläutert worden sind. Um den Verbinder 58 auch mit den Lotbahnen 38, 50 entlang der Rückseiten der Solarzellen 10, 14 stoffschlüssig verbinden zu können, wird entsprechend der Darstellung der Fig. 5b) auf die Abschnitte des Leiters 58, die entlang der Rückseiten der Solarzellen 10, 14 verlaufen, bereichsweise ein Lotmaterial 66 aufgebracht, so dass infolgedessen die erforderliche elektrisch leitende Verbindung hergestellt werden kann. Die Gestaltung des Verbinders 58 im Bereich der Rückseiten 18, 23 ergibt sich aus der Fig. 5b.

In Fig. 4c) ist eine erfindungsgemäße Ausführungsform eines Verbinders 68 dargestellt, der von der Grundstruktur her dem Verbinder 54 bzw. 16 außerhalb der Bereiche entspricht, die entlang zu verschaltender Frontseiten von Solarzellen verlaufen. Mit anderen Worten weist der Verbinder 68 außerhalb dieser Bereiche, also in den Bereichen der Rückseiten der Solarzellen 10, 14 eine Struktur auf, die aus einer aus Aluminium oder Kupfer bestehenden Streifenfolie 142 und auf deren Flachseiten verlaufenden Lotschichten 144, 146 besteht, also ein Verbinder, der der Schnittdarstellung der Fig. 5a) entspricht. Nachdem der Verbinder 68 mit dem Busbar 24 der Frontseite 20 der Solarzelle 12 verbunden ist, wird die Zinnschicht 146 z. B. mittels eines Stempels derart strukturiert, dass sich eine Gestaltung ergibt, durch die die auffallende Strahlung reflektiert wird, um sodann entsprechend zuvor erfolgter Erläuterungen von der Frontglasscheibe zurückgespiegelt zu werden. Zusätzlich kann auf der Oberseite der Struktur 148 eine reflektierende Schicht 150 zuvor erläuterter Art aufgetragen werden.

## Patentansprüche

1. Verfahren zum Verbinden von Solarzellen (10, 12, 14) zur Herstellung eines Solarzellenmoduls mittels abwechselnd entlang von Rückseiten (18) und Busbars (22, 24, 26) aufweisenden Frontseiten (20) von aufeinanderfolgenden Solarzellen (10, 12, 14) verlaufenden und mit diesen elektrisch leitend verbundenen Verbindern (16, 54, 68), deren Anzahl der der Busbars entspricht und die jeweils streifenförmiger Geometrie mit gegenüberliegenden Flachseiten aufweisen, wobei die solarzellenfrontseitig verlaufende solarzellenabgewandte Flachseite mit einem Material und/oder einer Struktur (156, 148, 150) versehen wird, das bzw. die Strahlen reflektiert und in den verbleibenden Abschnitten des Verbinders unveränderte strukturelle Eigenschaften vorhanden sind, wobei als Solarzellen solche mit einem siliciumbasierten und p- oder n-leitenden Wafer (42, 40) verwendet werden, auf dessen Rückseite eine lokale Öffnungen (44, 46) aufweisende Schicht (43) aus passivierendem dielektrischen Material angeordnet wird, die von einer die Rückseite des Wafers vollflächig abdeckenden aus Aluminium bestehenden oder Aluminium enthaltenden gesinterten Schicht (48) abgedeckt wird, wobei auf die Sinterschicht im Bereich des zu kontaktierenden Verbinders mittels Ultraschall ein aus Lotmaterial bestehender Streifen (50) aufgetragen wird, wobei der Verbinder (16, 54, 68) mit dem Streifen stoffschlüssig verbunden wird, wobei der Verbinder auf beiden Flachseiten Lotmaterial (144, 146) aufweist und wobei das Versehen mit dem reflektierenden Material und/oder der Struktur während oder nach dem Verbinden der Solarzelle mit dem Verbinder erfolgt.

2. Verfahren nach Anspruch 1,
**dadurch gekennzeichnet,**
**dass** als das reflektierende Material zumindest ein solches aus der Gruppe Ag, Al₂O₃, Ti02, Aluminiumfolie mit gegebenenfalls Schutzoxid, reflektierende Farbe verwendet wird.

3. Verfahren nach Anspruch 1,
**dadurch gekennzeichnet,**
**dass** die die Strahlung reflektierende Struktur ausschließlich oder im Wesentlichen ausschließlich in der aus dem entlang der solarzellenabgewandten Flachseite verlaufenden Schicht aus Lotmaterial insbesondere durch Prägen ausgebildet wird.

4. Verfahren nach zumindest einem der vorherigen Ansprüche,
**dadurch gekennzeichnet,**
**dass** als Verbinder ein aus Kupfer oder Aluminium bestehender oder enthaltender Folienstreifen mit einer Breite B mit 1 mm ≤ B ≤ 3 mm und/oder einer Dicke D_{F} mit 50 µm ≤ DF ≤ 250 µm verwendet wird.

5. Verfahren nach zumindest einem der vorherigen Ansprüche,
**dadurch gekennzeichnet,**
**dass** das Lotmaterial auf der Flachseite mit einer Schichtdicke D_{L} mit 10 µm ≤ D_{L} ≤ 20 µm aufgetragen wird.

6. Verfahren nach zumindest einem der vorherigen Ansprüche,
**dadurch gekennzeichnet,**
**dass** das reflektierende Material mit einer Schichtdicke D_{R} mit 0,1 µm ≤ D_{R} ≤ 5 µm, insbesondere mit 1 µm ≤ D_{R} ≤ 2 µm aufgetragen wird.

## Claims

1. Method for connecting solar cells (10, 12, 14) to manufacture a solar cell module by means of connectors (16, 54, 68) running alternatingly along front faces (20), having rear faces (18) and busbars (22, 24, 26), of consecutive solar cells (10, 12, 14) and connected in electrically conducting manner to said solar cells and whose number corresponds to that of said busbars and which each have a strip-like geometry with opposite flat faces, where the flat face facing away from said solar cell and running on the front face of said solar cell is provided with a material and/or a structure (156, 148, 150) which reflects radiation and unaltered structural properties are present in the remaining sections of said connector, where solar cells with a silicon-based and p-conducting or n-conducting wafer (42, 40) are used on whose rear face is arranged a layer (43) of passivating dielectric material having local openings (44, 46) and covered by a sintered layer (48) covering the full surface of the rear face of said wafer and consisting of aluminium or containing aluminium, where a strip (50) consisting of solder material is applied by means of ultrasound onto said sintered layer in the area of the connector to be contacted, where said connector (16, 54, 68) is connected to said strip in substance-to-substance manner, where said connector has solder material (144, 146) on both flat faces and where provision with the reflecting material and/or structure takes place during or after connection of said solar cell to said connector.

2. Method according to claim 1,
wherein
at least one material from the group of Ag, Al₂O₃, TiO₂, aluminium foil, where necessary with protective oxide, or a reflecting paint is used as the reflecting material.

3. Method according to claim 1,
wherein
the structure reflecting the radiation is formed exclusively or substantially exclusively in the layer of solder material running along the flat face facing away from the solar cell, in particular by stamping.

4. Method according to at least one of the preceding claims,
wherein
a foil strip consisting of or containing copper or aluminium with a width B of 1 mm ≤ B ≤ 3 mm and/or a thickness D_{F} of 50 µm ≤ D_{F} ≤ 250 µm is used as the connector.

5. Method according to at least one of the preceding claims,
wherein
the solder material is applied on the flat face with a layer thickness D_{L} of 10 µm ≤ DL ≤ 20 µm.

6. Method according to at least one of the preceding claims,
wherein
the reflecting material is applied with a layer thickness D_{R} of 0.1 µm ≤ D_{R} ≤ 5 µm, in particular of 1 µm ≤ D_{R} ≤ 2 µm.

## Revendications

1. Procédé de connexion de cellules solaires (10, 12, 14) pour fabriquer un module solaire au moyen de connecteurs (16, 54, 68) s'étendant en alternance le long des faces arrière (18) et des faces avant (20) dotées de barres omnibus (22, 24, 26) de cellules solaires (10, 12, 14) successives, connectés à elles de manière conductrice, dont le nombre est égal à celui des barres omnibus et présentant chacun une géométrie en forme de bande avec côtés plats opposés, sachant que le côté plat détourné des cellules solaires et s'étendant du côté de la face avant des cellules solaires est pourvu d'un matériau et/ou d'une structure (156, 148, 150) qui réfléchit les rayons et sachant que des propriétés structurelles intactes existent dans les portions restantes du connecteur, sachant que sont utilisées comme cellules solaires des cellules avec un wafer (42, 40) à base de silicium et de conductivité p ou n au dos duquel est disposée une couche (43) de matériau diélectrique de passivation présentant des ouvertures locales (44, 46), laquelle couche est recouverte d'une couche frittée (48) constituée d'aluminium ou contenant de l'aluminium couvrant toute la surface du dos du wafer, sachant qu'une bande (50) constituée de matériau de brasage est appliquée au moyen d'ultrasons sur la couche frittée dans la zone du connecteur à contacter, sachant que le connecteur (16, 54, 68) est relié à la bande par liaison de matière, sachant que le connecteur présente du matériau de brasage (144, 146) sur les deux côtés plats et sachant que le matériau réfléchissant et/ou la structure sont pourvus pendant ou après la connexion de la cellule solaire au connecteur.

2. Procédé selon la revendication 1,
**caractérisé en ce**
**qu'**est utilisé comme matériau réfléchissant au moins un matériau du groupe Ag, Al₂O₃, TiO₂, film aluminium avec, le cas échéant, oxyde de protection, peinture réfléchissante.

3. Procédé selon la revendication 1,
**caractérisé en ce**
**que** la structure réfléchissant le rayonnement est constituée, notamment par estampage, exclusivement ou pratiquement exclusivement dans la couche en matériau de brasage s'étendant le long du côté plat détourné des cellules solaires.

4. Procédé selon au moins une des revendications précédentes,
**caractérisé en ce**
**qu'**est utilisé comme connecteur une bande de film contenant ou constituée de cuivre ou d'aluminium avec une largeur B telle que 1 mm ≤ B ≤ 3 mm et/ou une épaisseur D_{F} telle que 50 µm ≤ D_{F} ≤ 250 µm.

5. Procédé selon au moins une des revendications précédentes,
**caractérisé en ce**
**que** le matériau de brasage sur le côté plat est appliqué avec une épaisseur de couche D_{L} telle que 10 µm ≤ D_{L} ≤ 20 µm.

6. Procédé selon au moins une des revendications précédentes,
**caractérisé en ce**
**que** le matériau réfléchissant est appliqué avec une épaisseur de couche D_{R} telle que 0,1 µm ≤ D_{R} ≤ 5 µm, notamment telle que 1 µm ≤ D_{R} ≤ 2 µm.
